# EUROPEAN PATENT SPECIFICATION

(11) **EP 3 230 060 B1**
(45) Date of publication and mention of the grant of the patent: **01.09.2021**
(21) Application number: 15819874.7
(22) Date of filing: 08.12.2015
(51) Int. Cl.: B32B 27/08, C08K 3/10, C08K 3/32, C08K 5/32

(54) **LASER-DIRECT STRUCTURING OF POLYMERIC FILMS AND SHEETS AND METHODS OF MAKING**
LASER-DIREKTSTRUKTURIERUNG VON POLYMERFILMEN UND -FOLIEN SOWIE VERFAHREN ZUR HERSTELLUNG
STRUCTURATION DIRECTE AU LASER DE FILMS ET FEUILLES POLYMÈRES ET PROCÉDÉS DE FABRICATION

(30) Priority: 12.12.2014 US 201462091114 P
(43) Date of publication of application: 18.10.2017
(73) Proprietor: SHPP Global Technologies B.V., 4612 PX Bergen op Zoom (NL)
(72) Inventor: FENG, Wei, Shanghai 201203 (CN); TJAHJADI, Mahari, Shanghai 201203 (CN); WU, Tong, Shanghai 200240 (CN); AN, Yuxian, Shanghai 200231 (CN)
(74) Representative: Elzaburu S.L.P.
(86) International application number: PCT/IB2015/059447
(87) International publication number: WO 2016/092472

(56) References cited:
- EP-A2- 1 918 096
- DE-C1- 19 509 505
- None

## Description

### TECHNICAL FIELD

This disclosure relates to materials prepared using a laser-direct structuring (LDS) method. The LDS materials of the present disclosure comprise polymeric film or polymeric sheet structures containing a LDS additive and which can undergo laser-direct structuring and chemical plating to form conductive paths on their surface. The present disclosure finds use, for example, in the automotive, electronics, RFID, communications, and medical device industries.

### BACKGROUND

Laser-direct structuring (LDS) materials have been extensively used to make molded injection devices (MIDs) via single shot injection molding. In a typical LDS process, a computer-controlled laser beam travels over MIDs to activate a substrate's surface at locations where the conductive path is to be situated. The LDS additives release metallic nuclei which can be reduced to metal to form conductive paths in the subsequent chemical plating process. With a laser-direct structuring process, it is possible to obtain small conductive path widths (such as of 150 microns or less). In addition, the spacing between the conductive paths can also be small. As a result, MIDs formed from this process save space and weight in the end-use applications. Another advantage of laser-direct structuring is its flexibility. If the design of the circuit is changed, it is simply a matter of reprogramming the computer that controls the laser. Consequently, LDS treated MIDs save space and weight in the end-use applications. Compared to the existing methods such as metal-sheet stamping and 2-shot-molding, LDS facilitates, among other things, short development cycles, variation in design, cost reduction, miniaturization, diversification, and functionality.

A key challenge for this technology, however, is to develop LDS materials with robust plating performance while maintaining good mechanical properties. Also, laser structuring only happens on the surface of the injected part, thus most bulk material beneath the surface does not require the presence of LDS additives. LDS additives are expensive and can adversely affect other performance of the bulk materials, such as base resin degradation and filler disintegration during extrusion and molding, long-term stability problems, and lack of ductility.

Also, with emerging market trends, the appearance of a device is becoming increasingly important, especially in consumer electronics. It is well known that LDS materials are rendered dark or opaque owing to the presence of LDS additives and its carriers, which are characterized by a bigger particle size. Although light colored LDS materials with colorable characteristics and good mechanical properties have been reported, the technology used to prepare transparent LDS materials has not progressed. This is attributed to the fact that most LDS additives will affect light transmittance of the overall LDS material due to bigger particle sizes and the higher loading required to sufficient plating performance. Moreover, typically there is weak near-infra red (NIR) absorption for transparent materials which affects plating performance as well as peel strength between the plating layer and base substrate, such as a base resin.

Document EP1918096 describes a laser-cuttable, at least two-layer, white, oriented polyester film, comprising a base layer (B) in which a polyester, a white pigment or incompatible polymer, and an additive that absorbs laser energy are present, and also comprising at least one outer layer (A). Document DE19509505 describes a multilayered label having a base layer of plastic containing an additive which exhibits a colour change on irradiation with light, in particular a laser, and which is covered by one or more protective films.

### SUMMARY OF THE INVENTION

This disclosure relates to a polymeric film or polymeric sheet containing a LDS additive that addresses the problems associated with LDS additives in MIDs. The polymeric film or polymeric sheet can be extruded. In a co-extruded sheet, the top surface is made of an LDS-containing cap layer, which can be any commercial plastic, preferably a thermoplastic, as long as it can be extruded to form a film. The advantages of a LDS-containing sheet are many. Because it is in the form of a sheet, it can be used directly for flat applications. Secondly, the sheet can be shaped to form a three-dimensional (3-D) structure, which can be used directly as the final part or as an insert for the in-mold decoration (IMD) process. For a co-extruded structure, only the outer layer contains the LDS additives, thus the base resin can be selected from a variety of materials with virtually no compromise of its properties.

In one aspect, this disclosure relates to a polymeric sheet comprising a first cap layer comprising a first LDS additive, and a base layer, wherein the first cap layer contacts the base layer.

This disclosure also relates to an article of manufacture comprising a molded article formed from the polymeric sheet described above, wherein a conductive path is formed on the molded article and a metal layer is plated on the conductive path.

In yet another aspect, this disclosure relates to a method of forming an article comprising molding an article from the polymeric sheet described above, forming a conductive path on the molded article, and plating a metal layer onto the conductive path.

Furthermore, this disclosure relates to a method of forming an article comprising shaping the polymeric sheet described above into a three-dimensional structure, forming a conductive path on the three-dimensional structure, and plating a metal layer onto the conductive path.

In yet another aspect, this disclosure relates to a method of forming an article comprising the steps of inserting the polymeric sheet described above into a mold used for making an injection molded part, integrating the polymeric sheet into the injected molded part, forming a conductive path on the injected molded part, and plating a metal layer onto the conductive path.

Also, this disclosure relates to a single-layer polymeric film comprising a LDS additive wherein the single-layer polymeric film has the thickness in the range of from about 10 µm to about 12,500 µm (as used herein "µm" means micrometer or micron).

This disclosure further relates to an article of manufacture comprising a molded article formed from the single-layer polymeric film described above, wherein a conductive path is formed on the molded article and a metal layer is plated on the conductive path.

### DETAILED DESCRIPTION OF ILLUSTRATIVE EMBODIMENTS

Unless defined otherwise, all technical and scientific terms used herein have the same meaning as commonly understood by one of ordinary skill in the art to which this disclosure belongs. Although any methods and materials similar or equivalent to those described herein can be used in the practice or testing of the present disclosure, example methods and materials are now described.

As used herein, the term "hydrocarbyl" and "hydrocarbon" refers broadly to a substituent comprising carbon and hydrogen, optionally with 1 to 3 heteroatoms, for example, oxygen, nitrogen, halogen, silicon, sulfur, or a combination thereof; "alkyl" refers to a straight or branched chain, saturated monovalent hydrocarbon group; "alkylene" refers to a straight or branched chain, saturated, divalent hydrocarbon group; "alkylidene" refers to a straight or branched chain, saturated divalent hydrocarbon group, with both valences on a single common carbon atom; "alkenyl" refers to a straight or branched chain monovalent hydrocarbon group having at least two carbons joined by a carbon-carbon double bond; "cycloalkyl" refers to a non-aromatic monovalent monocyclic or multicylic hydrocarbon group having at least three carbon atoms, "cycloalkenyl" refers to a non-aromatic cyclic divalent hydrocarbon group having at least three carbon atoms, with at least one degree of unsaturation; "aryl" refers to an aromatic monovalent group containing only carbon in the aromatic ring or rings; "arylene" refers to an aromatic divalent group containing only carbon in the aromatic ring or rings; "alkylaryl" refers to an aryl group that has been substituted with an alkyl group as defined above, with 4-methylphenyl being an exemplary alkylaryl group; "arylalkyl" refers to an alkyl group that has been substituted with an aryl group as defined above, with benzyl being an exemplary arylalkyl group; "acyl" refers to an alkyl group as defined above with the indicated number of carbon atoms attached through a carbonyl carbon bridge (-C(=O)-); "alkoxy" refers to an alkyl group as defined above with the indicated number of carbon atoms attached through an oxygen bridge (-O-); and "aryloxy" refers to an aryl group as defined above with the indicated number of carbon atoms attached through an oxygen bridge (-O-).

Unless otherwise indicated, each of the foregoing groups can be unsubstituted or substituted, provided that the substitution does not significantly adversely affect synthesis, stability, or use of the compound. The term "substituted" as used herein means that at least one hydrogen on the designated atom or group is replaced with another group, provided that the designated atom's normal valence is not exceeded. When the substituent is oxo (i.e., =O), then two hydrogens on the atom are replaced. Combinations of substituents and/or variables are permissible provided that the substitutions do not significantly adversely affect synthesis or use of the compound. Exemplary groups that can be present on a "substituted" position include, but are not limited to, cyano; hydroxyl; nitro; azido; alkanoyl (such as a C₂₋₆ alkanoyl group such as acyl); carboxamido; C₁₋₆ or C₁₋₃ alkyl, cycloalkyl, alkenyl, and alkynyl (including groups having at least one unsaturated linkages and from 2 to 8, or 2 to 6 carbon atoms); C₁₋₆ or C₁₋₃ alkoxys; C₆₋₁₀ aryloxy such as phenoxy; C₁₋₆ alkylthio; C₁₋₆ or C₁₋₃ alkylsulfinyl; C₁₋₆ or C₁₋₃ alkylsulfonyl; aminodi(C₁₋₆ or C₁₋₃)alkyl; C₆₋₁₂ aryl having at least one aromatic rings (e.g., phenyl, biphenyl, naphthyl, or the like, each ring either substituted or unsubstituted aromatic); C₇₋₁₉ arylalkyl having 1 to 3 separate or fused rings and from 6 to 18 ring carbon atoms; or arylalkoxy having 1 to 3 separate or fused rings and from 6 to 18 ring carbon atoms, with benzyloxy being an exemplary arylalkoxy.

### Single-Layer Polymeric Films

In one aspect, this disclosure relates to a single-layer polymeric film or monolithic film comprising a polymeric resin and LDS additive. This invention disclosure also relates to an LDS material created from such single-layer polymeric film, wherein the film has been subjected to laser-direct structuring and electroless plating steps.

In one embodiment, the single-layer polymeric film is flexible. In another embodiment, the single-layer polymeric film comprising the LDS additive ranges in thickness from about 10 µm to about to 12,500 µm. In certain embodiments, the thickness ranges from 50 µm to about to 100 µm. For example, the thickness of the single-layer polymeric film can be from 10, 20, 30, 40, 50, 60, 70, 80, 90, 100, 200, 300, 400, 500, 600, 700, 800, 900, 1000, 1100, 1200, 1300, 1400, 1500, 1600, 1700, 1800, 1900, 2000, 210, 2200, 2300, 2400, 2500, 2600, 2700, 2800, 2900, 3000, 3100, 3200, 3300, 3400, 3500, 3600, 3700, 3800, 3900, 4000, 4100, 4200, 4300, 4400, 4500, 4600, 4700, 4800, 4900, 5000, 5100, 5200, 5300, 5400, 5500, 5600, 5700, 5800, 5900, 6000, 6100, 6200, 6300, 6400, 6500, 6600, 6700, 6800, 6900, 7000, 7100, 7200, 7300, 7400, 7500, 7600, 7700, 7800, 7900, 8000, 8100, 8200, 8300, 8400, 8500, 8600, 8700, 8800, 8900, 9000, 9100, 9200, 9300, 9400, 9500, 9600, 9700, 9800, 9900, 10000, 10100, 10200, 10300, 10400, 10500, 10600, 10700, 10800, 10900, 11000, 11100, 11200, 11300, 11400, 11500, 11600, 11700, 11800, 11900, 12000, 1200, 1200, 12300, 12400, or 12500 µm, or within a range defined by any two of these values.

In one embodiment, a second layer comprising an LDS additive is adhered to the single-layer polymeric film, to form a dual-layer polymeric film, before or after the single-layer polymeric film comprising LDS additives has been subjected to laser-direct structuring and electroless plating. After the formation of the dual-layer film, the second layer may be subjected to laser-direct structuring and electroless plating. Specific patterns, e.g. for electronic circuitry, can be designed not only in the planar direction but also in a direction nominally perpendicular (non-planar) to the surface of the dual-layer polymeric film. Similarly, additional layers, each containing a LDS additive, may also form an embodiment of this disclosure.

The overall thickness of the dual or multiple-layer polymeric films is similar to that of the single-layer polymeric film, that is, in the range of from about 10 µm to about 12,500 µm or, in other embodiments, from 50 µm to about to 100 µm.

The single-layer polymeric film can be formed by various film making processes, including thermoforming, extrusion, injection molding, compression molding, blow molding, film blowing, rotational molding, solution casting, resin transfer molding including vacuum resin-transfer molding, melt-casting, in-situ polymerization, extrusion coating, calendar rolling, skiving, and films from non-woven fibers and nanofibers. The process chosen for making the film can depend on the polymeric resin used to make the single-layer polymeric film.

In some embodiments, the single layer polymeric film comprises from about 0.1 to about 10% by weight, based on the weight of the single-layer film, an ingredient selected from the group consisting of a dye, a pigment, a colorant, and a combination thereof.

In one embodiment, the single-layer polymeric film or the multiple-layer polymeric film can be molded into 3-D structures by standard thermoforming methods. The laser-direct structuring and the electroless plating steps can be performed before or after the thermoforming step to prepare the final LDS materials.

For example, using the thermoforming step, the single-layer or the multiple-layer polymeric film can be adhered to a substrate that makes up the final product. The laser-direct structuring and the electroless plating step can be accomplished before or after the adhesion of the single-layer polymeric film to the substrate. The flexibility of the single-layer film and the multiple-layer film helps conform to the shape of a 2-D (flat) or a 3-D shaped substrate.

In another aspect, an article of manufacture comprising a molded article formed from the single-layer (or multiple-layer) polymeric film is prepared. The film can be used as the final part or as an intermediate part of the final part. In one aspect, the molded article is planar, cylindrical, spherical, annular, tubular, ovoid, a regular 3-D shape, or an irregular 3-D shape. The articles can be a computer, a cell phone, communications equipment, a medical device, an RFID device, or an automotive part.

### Multi-Layer Polymeric Sheet

In another aspect, this disclosure relates to a multi-layer polymeric sheet comprising at least one cap layer in contact with at least one base layer, wherein the cap layer comprises a LDS additives and the base layer does not.

The cap layer comprises a polymeric resin, LDS additives, and, optionally, other ingredients. In one embodiment, the multi-layer polymeric sheet is flexible. In another embodiment, the cap layer ranges in thickness from about 10 µm to about to 12,500 µm, and more particularly, from about 50 µm to about to 100 µm. For example, the thickness of the cap layer can be from 10, 20, 30, 40, 50, 60, 70, 80, 90, 100, 200, 300, 400, 500, 600, 700, 800, 900, 1000, 1100, 1200, 1300, 1400, 1500, 1600, 1700, 1800, 1900, 2000, 210, 2200, 2300, 2400, 2500, 2600, 2700, 2800, 2900, 3000, 3100, 3200, 3300, 3400, 3500, 3600, 3700, 3800, 3900, 4000, 4100, 4200, 4300, 4400, 4500, 4600, 4700, 4800, 4900, 5000, 5100, 5200, 5300, 5400, 5500, 5600, 5700, 5800, 5900, 6000, 6100, 6200, 6300, 6400, 6500, 6600, 6700, 6800, 6900, 7000, 7100, 7200, 7300, 7400, 7500, 7600, 7700, 7800, 7900, 8000, 8100, 8200, 8300, 8400, 8500, 8600, 8700, 8800, 8900, 9000, 9100, 9200, 9300, 9400, 9500, 9600, 9700, 9800, 9900, 10000, 10100, 10200, 10300, 10400, 10500, 10600, 10700, 10800, 10900, 11000, 11100, 11200, 11300, 11400, 11500, 11600, 11700, 11800, 11900, 12000, 1200, 1200, 12300, 12400, or 12500 µm, or within a range defined by any two of these values.

The base layer comprises a polymeric resin, and, optionally, other ingredients. The base layer comprises substantially no LDS additives. In another embodiment, the base layer ranges in thickness from about 10 µm to about 12,400 µm, from about 150 µm to about 250 µm, and/or from about 75 µm to about 250 µm. For example, the thickness of the base layer can be from Stated another way, the thickness of the base layer can be from 10, 20, 30, 40, 50, 60, 70, 80, 90, 100, 200, 300, 400, 500, 600, 700, 800, 900, 1000, 1100, 1200, 1300, 1400, 1500, 1600, 1700, 1800, 1900, 2000, 210, 2200, 2300, 2400, 2500, 2600, 2700, 2800, 2900, 3000, 3100, 3200, 3300, 3400, 3500, 3600, 3700, 3800, 3900, 4000, 4100, 4200, 4300, 4400, 4500, 4600, 4700, 4800, 4900, 5000, 5100, 5200, 5300, 5400, 5500, 5600, 5700, 5800, 5900, 6000, 6100, 6200, 6300, 6400, 6500, 6600, 6700, 6800, 6900, 7000, 7100, 7200, 7300, 7400, 7500, 7600, 7700, 7800, 7900, 8000, 8100, 8200, 8300, 8400, 8500, 8600, 8700, 8800, 8900, 9000, 9100, 9200, 9300, 9400, 9500, 9600, 9700, 9800, 9900, 10000, 10100, 10200, 10300, 10400, 10500, 10600, 10700, 10800, 10900, 11000, 11100, 11200, 11300, 11400, 11500, 11600, 11700, 11800, 11900, 12000, 1200, 1200, 12300, or 12400 µm, or within a range defined by any two of these values.

In certain embodiments, the cap layer is from about 5% to about 30% of the total thickness of the polymeric sheet. For example, the cap layer is from about 5, 6, 7, 8, 9, 10, 11, 12, 13, 14, 15, 16, 17, 18, 19, 20, 21, 22, 23, 24, 25, 26, 27, 28, 29, or 30% of the total thickness of the polymer sheet, or within a range defined by any two of these values.

The polymeric sheet comprising at least one cap layer and one base layer can be formed by co-extrusion. The cap layer and the base layer can also be individually formed and fused together in adhesive contact. The cap layer and the base layer can be made on an individual basis by various film making processes such as thermoforming, extrusion, injection molding, compression molding, solution casting, resin transfer molding including vacuum resin-transfer molding, melt-casting, in-situ polymerization, extrusion coating, calendar rolling, skiving, and films from non-woven fibers and nanofibers. The process chosen for making the cap layer and base layer can depend on the polymeric resin used to each layer.

The cap layer and the base layer can comprise the same polymeric resin or a different polymeric resin. Generally, the cap layer and the base layer should have good compatibility for adhesion during subsequent processing and use.

A key aspect of the present disclosure is the flexibility available from utilizing the polymeric sheet described herein. For example, the cap layer does not have to be present on the entire surface of the base layer. In this way, the cap layer may be present only in the areas and/or patterns that will require plating. This provides an economical and precision advantage. For example, the cap layer may cover from 10, 20, 30, 40, 50, 60, 70, 80, 90, or 100% of the base substrate surface, or within a range defined by any two of these values.

In one embodiment, the polymeric sheet comprises more than one cap layer. For example, the polymeric sheet can have one base layer and two cap layers: a first cap layer, and a second cap layer, wherein the second cap layer is situated between the first cap layer and the base layer. The first cap layer and the second cap layer comprise a polymeric resin and an LDS additive. The first cap layer and the second cap layer may be different in chemical and/or physical composition. For example, the first and second cap layers may have different polymeric resin, different LDS additive, different concentration of LDS additive, and/or different thicknesses. The first and second cap layers may be situated side-by-side or one on top of the other. In one embodiment, the based layer has at least two sides and a second cap layer is in contact with the base layer on an opposite side of that of the first cap layer, and the second cap layer comprises a second LDS additive different from that in the first cap layer. In yet another embodiment, a the concentration of LDS additive varies in one direction and/or on location as opposed to another, and/or the thickness of the cap layer varies as well.

This disclosure also relates to a polymeric sheet comprising a cap layer and a base layer that forms a LDS material by the subsequent processing steps of laser-direct structuring and electroless plating. In one embodiment, a second cap layer is adhered to the first cap layer after the first cap layer has been subjected to laser-direct structuring and electroless plating. Specific conductive patterns, for example circuitry patterns, can be designed not only in the planar direction but also in a direction nominally perpendicular through the surface of the polymeric sheet.

In one embodiment, the LDS material may include stacking or otherwise combining of the multi-layer polymeric sheets, with each polymeric sheet comprising a base layer and at least one cap layer. As with the cap layers, the base layers is such combinations may also be different in chemical and/or physical composition, including differences in type of polymeric resin, thickness, molecular weight, or filler materials. Given the flexibility of configuration of the polymeric sheets, LDS materials may be formed with different circuitry, color, or plating patterns in different locations and/or surfaces of the overall LDS material.

In one embodiment, the polymeric sheet can be molded into 3-D structures by standard thermoforming methods. This also includes adhering the polymeric sheet on a substrate that makes up the final product. The laser-direct structuring and the electroless plating step can, for example, be accomplished before or after contacting the polymeric sheet on the substrate. In certain aspects, the flexibility of the polymeric sheet allows the sheet to conform to the shape of a 2-D (flat) or a 3-D shaped substrate.

In one embodiment, the cap layer comprises from about 0.1 to about 10% by weight, based on the weight of the cap layer, of an ingredient selected from the group consisting of a dye, a pigment, a colorant, and a combination thereof.

This disclosure also relates to an article of manufacture comprising a molded article formed from multi-layer polymeric sheets described herein, where a conductive path is formed on the molded article and a metal layer is plated on the conductive path. In one aspect, the molded article is cylindrical, spherical, annular, tubular, ovoid, a regular 3-D shape, or an irregular 3-D shape. The articles can be a computer, a cell phone, communications equipment, a medical device, an RFID device, or an automotive part.

### Substrate

In one embodiment, the single-layer (or the multiple-layer) polymeric film or the multi-layer polymeric sheet described herein are adhered to a substrate of interest. Such substrates can be made of any material, not necessarily polymeric. For example, it could be a polymeric resin as described herein, or ceramic, glass, rubber, wood, organic solid materials such as wax, and inorganic solid materials such as various metals and their salts including oxides.

In one aspect, the substrate is planar, cylindrical, spherical, annular, tubular, ovoid, a regular 3-D shape, or an irregular 3-D shape. Depending on the shape and configuration of the substrate, the single-layer polymeric film or multi-layer polymeric sheet may be applied on one or more surfaces of the substrate, including a top surface or bottom surface of a planar substrate, or an inside surface of substrates having cavities, such as those having an annular or tubular shape.

### Polymeric Resin

The single-layer polymeric film and the multilayer polymeric sheet (including a base layer and a cap layer) comprise a polymeric resin. The polymeric resin includes one or more polymers, blends, alloys, homogeneous and non-homogeneous mixtures, copolymers, and oligomers.

Such polymers comprise a thermoplastic resin or a thermoset resin. The thermoplastic resins include polycarbonate, acrylonitrile-butadiene-styrene, polyimide, a poly(arylene ether), polyamide, polyester, , polyphthalamide, polyphenylene oxide, polyetherimide, polyketones, polyetherketones, polybenzimidazole, polystyrene, polymethyl methacrylate, polyvinylchloride, cellulose-acetate resin, polyacrylonitrile, polysulphone, polyphenylenesulfide, fluoropolymers, polycarbonate/acrylonitrile-butadiene-styrene resin blend, acrylonitrile-ethylene/propylene-styrene, methyl methacrylate-butadiene-styrene, acrylonitrile-butadiene-methyl methacrylate-styrene, acrylonitrile-n-butyl acrylate-styrene, rubber modified polystyrene, polyethylene, polypropylene, silicone, polyamide elastomer, and combinations thereof. The thermoplastic resins also include thermoplastic elastomers such as polyamide and polyester based elastomers. The base substrate can also comprise blends and/or other types of combination of resins described above.

Thermosetting polymers can also be used to form the single-layer polymeric film, the cap layer of the polymeric sheet, the base layer of the polymeric sheet, and the substrate of the LDS materials of the present disclosure. Thermosetting resins include phenol resin, urea resin, melamine-formaldehyde resin, urea-formaldehyde latex, xylene resin, diallyl phthalate resin, epoxy resin, aniline resin, furan resin, polyurethane, and combinations thereof.

The single-layer polymeric film, multi-layer polymeric sheet, and the substrate of interest may also be thermoplastic elastomers, or thermoset-based elastomers, or crosslinked materials, for example, dendrimers.

### Polycarbonate as Polymeric Resin

The single-layer polymeric film, the cap layer of the polymeric sheet, the base layer of the polymeric sheet, and the substrate of the LDS materials may comprise polycarbonate polymer. "Polycarbonate" as used herein means a polymer or copolymer having repeating structural carbonate units of formula (1) 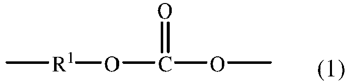 wherein at least 60 percent of the total number of R¹ groups are aromatic, or each R¹ contains at least one C₆₋₃₀ aromatic group. Specifically, each R¹ can be derived from a dihydroxy compound such as an aromatic dihydroxy compound of formula (2) or a bisphenol of formula (3).

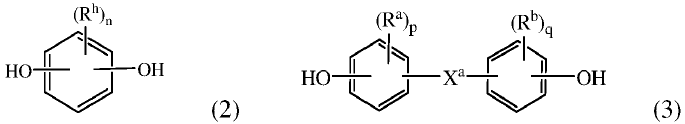

In formula (2), each Rh is independently a halogen atom, for example bromine, a C₁₋₁₀ hydrocarbyl group such as a C₁₋₁₀ alkyl, a halogen-substituted C₁₋₁₀ alkyl, a C₆₋₁₀ aryl, or a halogen-substituted C₆₋₁₀ aryl, and n is 0 to 4.

In formula (3), Ra and Rb are each independently a halogen, C₁₋₁₂ alkoxy, or C₁₋₁₂ alkyl, and p and q are each independently integers of 0 to 4, such that when p or q is less than 4, the valence of each carbon of the ring is filled by hydrogen. In an embodiment, p and q is each 0, or p and q is each 1, and Ra and Rb are each a C₁₋₃ alkyl group, specifically methyl, disposed meta to the hydroxy group on each arylene group. Xa is a bridging group connecting the two hydroxy-substituted aromatic groups, where the bridging group and the hydroxy substituent of each C₆ arylene group are disposed ortho, meta, or para (specifically para) to each other on the C₆ arylene group, for example, a single bond, -O-, -S-, -S(O)-, -S(O)2-, -C(O)-, or a C₁₋₁₈ organic group, which can be cyclic or acyclic, aromatic or non-aromatic, and can further comprise heteroatoms such as halogens, oxygen, nitrogen, sulfur, silicon, or phosphorous. For example, Xa can be a substituted or unsubstituted C₃₋₁₈ cycloalkylidene; a C₁₋₂₅ alkylidene of the formula -C(Rc)(Rd) - wherein Rc and Rd are each independently hydrogen, C₁₋₁₂ alkyl, C₁₋₁₂ cycloalkyl, C₇₋₁₂ arylalkyl, C₁₋₁₂ heteroalkyl, or cyclic C₇₋₁₂ heteroarylalkyl; or a group of the formula -C(=Re)- wherein Re is a divalent C₁₋₁₂ hydrocarbon group.

Some illustrative examples of specific dihydroxy compounds include bisphenol compounds such as 4,4'-dihydroxybiphenyl, 1,6-dihydroxynaphthalene, 2,6-dihydroxynaphthalene, bis(4-hydroxyphenyl)methane, bis(4-hydroxyphenyl)diphenylmethane, bis(4-hydroxyphenyl)-1-naphthylmethane, 1,2-bis(4-hydroxyphenyl)ethane, 1,1-bis(4-hydroxyphenyl)-1-phenylethane, 2-(4-hydroxyphenyl)-2-(3-hydroxyphenyl)propane, bis(4-hydroxyphenyl)phenylmethane, 2,2-bis(4-hydroxy-3-bromophenyl)propane, 1,1-bis (hydroxyphenyl)cyclopentane, 1,1-bis(4-hydroxyphenyl)cyclohexane, 1,1-bis(4-hydroxyphenyl)isobutene, 1,1-bis(4-hydroxyphenyl)cyclododecane, trans-2,3-bis(4-hydroxyphenyl)-2-butene, 2,2-bis(4-hydroxyphenyl)adamantane, alpha,alpha'-bis(4-hydroxyphenyl)toluene, bis(4-hydroxyphenyl)acetonitrile, 2,2-bis(3-methyl-4-hydroxyphenyl)propane, 2,2-bis(3-ethyl-4-hydroxyphenyl)propane, 2,2-bis(3-n-propyl-4-hydroxyphenyl)propane, 2,2-bis(3-isopropyl-4-hydroxyphenyl)propane, 2,2-bis(3-sec-butyl-4-hydroxyphenyl)propane, 2,2-bis(3-t-butyl-4-hydroxyphenyl)propane, 2,2-bis(3-cyclohexyl-4-hydroxyphenyl)propane, 2,2-bis(3-allyl-4-hydroxyphenyl)propane, 2,2-bis(3-methoxy-4-hydroxyphenyl)propane, 2,2-bis(4-hydroxyphenyl)hexafluoropropane, 1,1-dichloro-2,2-bis(4-hydroxyphenyl)ethylene, 1,1-dibromo-2,2-bis(4-hydroxyphenyl)ethylene, 1,1-dichloro-2,2-bis(5-phenoxy-4-hydroxyphenyl)ethylene, 4,4'-dihydroxybenzophenone, 3,3-bis(4-hydroxyphenyl)-2-butanone, 1,6-bis(4-hydroxyphenyl)-1,6-hexanedione, ethylene glycol bis(4-hydroxyphenyl)ether, bis(4-hydroxyphenyl)ether, bis(4-hydroxyphenyl)sulfide, bis(4-hydroxyphenyl)sulfoxide, bis(4-hydroxyphenyl)sulfone, 9,9-bis(4-hydroxyphenyl)fluorene, 2,7-dihydroxypyrene, 6,6'-dihydroxy-3,3,3',3'- tetramethylspiro(bis)indane ("spirobiindane bisphenol"), 3,3-bis(4-hydroxyphenyl)phthalimide, 2,6-dihydroxydibenzo-p-dioxin, 2,6-dihydroxythianthrene, 2,7-dihydroxyphenoxathin, 2,7-dihydroxy-9,10-dimethylphenazine, 3,6-dihydroxydibenzofuran, 3,6-dihydroxydibenzothiophene, and 2,7-dihydroxycarbazole; resorcinol, substituted resorcinol compounds such as 5-methyl resorcinol, 5-ethyl resorcinol, 5-propyl resorcinol, 5-butyl resorcinol, 5-t-butyl resorcinol, 5-phenyl resorcinol, 5-cumyl resorcinol, 2,4,5,6-tetrafluoro resorcinol, 2,4,5,6-tetrabromo resorcinol, or the like; catechol; hydroquinone; substituted hydroquinones such as 2-methyl hydroquinone, 2-ethyl hydroquinone, 2-propyl hydroquinone, 2-butyl hydroquinone, 2-t-butyl hydroquinone, 2-phenyl hydroquinone, 2-cumyl hydroquinone, 2,3,5,6-tetramethyl hydroquinone, 2,3,5,6-tetra-t-butyl hydroquinone, 2,3,5,6-tetrafluoro hydroquinone, 2,3,5,6-tetrabromo hydroquinone, or the like.

Specific dihydroxy compounds include resorcinol, 2,2-bis(4-hydroxyphenyl) propane ("bisphenol A" or "BPA"), 3,3-bis(4-hydroxyphenyl) phthalimidine, 2-phenyl-3,3'-bis(4-hydroxyphenyl) phthalimidine (also known as N-phenyl phenolphthalein bisphenol, "PPPBP", or 3,3-bis(4-hydroxyphenyl)-2-phenylisoindolin-1-one), 1,1-bis(4-hydroxy-3-methylphenyl)cyclohexane (DMBPC), and from bisphenol A and 1,1-bis(4-hydroxy-3-methylphenyl)-3,3,5-trimethylcyclohexane (isophorone bisphenol).

"Polycarbonate" as used herein also includes copolymers comprising carbonate units and ester units ("poly(ester-carbonate)s", also known as polyester-polycarbonates). Poly(ester-carbonate)s further contain, in addition to recurring carbonate chain units of formula (1), repeating ester units of formula (4) 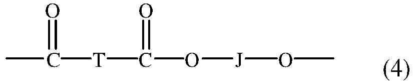 wherein J is a divalent group derived from a dihydroxy compound (which includes a reactive derivative thereof), and can be, for example, a C₂₋₁₀ alkylene, a C₆₋₂₀ cycloalkylene a C₆₋₂₀ arylene, or a polyoxyalkylene group in which the alkylene groups contain 2 to 6 carbon atoms, specifically, 2, 3, or 4 carbon atoms; and T is a divalent group derived from a dicarboxylic acid (which includes a reactive derivative thereof), and can be, for example, a C₂₋₂₀ alkylene, a C₆₋₂₀ cycloalkylene, or a C₆₋₂₀ arylene. Copolyesters containing a combination of different T and/or J groups can be used. The polyester units can be branched or linear.

Specific dihydroxy compounds include aromatic dihydroxy compounds of formula (2) (e.g., resorcinol), bisphenols of formula (3) (e.g., bisphenol A), a C₁₋₈ aliphatic diol such as ethane diol, n-propane diol, i-propane diol, 1,4-butane diol, 1,6-cyclohexane diol, 1,6-hydroxymethylcyclohexane, or a combination comprising at least one of the foregoing dihydroxy compounds. Aliphatic dicarboxylic acids that can be used include C₆₋₂₀ aliphatic dicarboxylic acids (which includes the terminal carboxyl groups), specifically linear C₈₋₁₂ aliphatic dicarboxylic acid such as decanedioic acid (sebacic acid); and alpha, omega-C₁₂ dicarboxylic acids such as dodecanedioic acid (DDDA). Aromatic dicarboxylic acids that can be used include terephthalic acid, isophthalic acid, naphthalene dicarboxylic acid, 1,6-cyclohexane dicarboxylic acid, or a combination comprising at least one of the foregoing acids. A combination of isophthalic acid and terephthalic acid wherein the weight ratio of isophthalic acid to terephthalic acid is 91:9 to 2:98 can be used.

Specific ester units include ethylene terephthalate units, n-proplyene terephthalate units, n-butylene terephthalate units, ester units derived from isophthalic acid, terephthalic acid, and resorcinol (ITR ester units), and ester units derived from sebacic acid and bisphenol A. The molar ratio of ester units to carbonate units in the poly(ester-carbonate)s can vary broadly, for example 1:99 to 99:1, specifically, 10:90 to 90:10, more specifically, 25:75 to 75:25, or from 2:98 to 15:85.

### LDS Additives

As used herein, a laser-direct structuring additive refers to metal containing additives suitable for use in a laser-direct structuring process. To that end, as discussed more fully herein, an LDS additive is selected such that, after activating with a laser, a conductive path can be formed by a subsequent standard metallization or plating process. As such, when the LDS additive is exposed to a laser, elemental metal is released or activated. The laser thus draws the circuit pattern onto the polymeric part and leaves behind a roughened surface containing embedded metal particles. These particles act as nuclei for the crystal growth during a subsequent metallization or plating process, such as a copper plating process or other plating processes, including gold plating, nickel plating, silver plating, zinc plating, tin plating or the like.

The LDS additive concentration in the cap layer of the polymeric sheet is in the range of from about 2% to 5% by weight of the individual layer. For example, the LDS additive may be from about 2, 3, 4, or 5% by weight, or within a range defined by any two of these values.

According to aspects of the disclosure, the laser-direct structuring additive can comprise one or more metal oxides, including for example, oxides of chromium, copper, or combinations thereof. These laser-direct structuring additives can also be provided having spinel type crystal structures. An exemplary and non-limiting example of a commercially available laser-direct structuring additive includes PK3095 black pigment, commercially available from Ferro Corp., USA. The PK3095, for example, comprises chromium oxides (Cr₂O₃, Cr₂O₄²⁻, Cr₂O₇²⁻) and oxides of copper (CuO), as determined using XPS. The PK3095 black pigment also has a spinel type crystal structure. Another exemplary commercially available laser-direct structuring additive is the Black 1G pigment black 28 commercially available from The Shepherd Color company. The Black 1G pigment black 28 comprises copper chromate and has a pH of about 7.3. The Black 1G pigment also has a spinel type crystal structure.

The LDS additive may comprise laser sensitive materials (e.g., at 1064 nm wavelength) including the metal oxide or salts of Sb, Cu, Pb, Ni, Fe, Sn, Cr, Mn, Ag, Au and Co. The LDS additive is selected from the group consisting of a copper chromium oxide spinel, a copper hydroxide phosphate, a copper phosphate, a copper sulfate, a cuprous thiocyanate, an organic metal complex, a palladium/palladium-containing heavy metal complex, a metal oxide, a metal oxide-coated filler, antimony doped tin oxide coated on mica, a copper containing metal oxide, a zinc containing metal oxide, a tin containing metal oxide, a magnesium containing metal oxide, an aluminum containing metal oxide, a gold containing metal oxide, a silver containing metal oxide, or a combination thereof.

In certain aspects, the LDS additives comprise metal oxide containing copper, for example, copper chromium oxide spinel, copper hydroxide phosphate, and/or copper phosphate.

### Process of Making the LDS Materials

MIDs integrate electrical and mechanical functions in a single construction unit. Compared to conventional printed circuit boards (PCB) technology, the injection molded substrate for MIDs can be in three dimensions. MIDs can integrate electrical and mechanical elements into almost any shape of an interconnected device allowing entirely new functions to be created. The method of the present disclosure generally comprises (1) preparing the LDS-containing polymeric film or the polymeric sheet; (2) laser-direct structuring of a conductive path on the LDS-containing layer; and (3) plating a metal layer onto the conductive path.

In injection molding, LDS additives are mixed with the thermoplastic granules or chips in a compounding operation. LDS additives can be added to a variety of thermoplastics. A single-shot injection molding is used to produce the parts that are then laser structured. The polymeric films and sheets may otherwise be formed by the manufacturing processes described previously. If more than one layer is being produced (e.g. multiple single-layer polymeric films or the multiple-layer polymeric sheet) co-extrusion is a preferred route.

The polymeric films and the polymeric sheets described herein can be adhered to a substrate after their preparation, after laser-direct structuring of conductive paths on the LDS-containing layer, or after the plating of the metal layer. The substrate is selected according to the use of the material in the field, for example, in electronic applications, one may use polycarbonate, acrylonitrile-butadiene-styrene, or the polymethyl methacrylate material. The substrate is selected considering the harshness of the use conditions, such as temperature, chemical environment, weather conditions, level of human interaction, mechanical wear and handle-ability.

Typically, a laser is used to form an activated/conductive path during a laser structuring step. In one aspect, laser direct structuring comprises laser etching, and in a further aspect, laser etching is carried out to provide an activated surface. In a further aspect, at least one laser beam draws at least one pattern on the surface of an LDS-containing layer during the laser structuring step. In a still further aspect, the LDS additive may release at least one metallic nucleus. In yet a further aspect, the at least one metallic nucleus that has been released may act as a catalyst for a reductive copper plating process.

In a further aspect, laser etching is carried out at about 1 w to about 10 w power with a frequency from about 30 kHz to about 110 kHz and a speed of about 1 m/s to about 5 m/s. In a still further aspect, laser etching is carried out at about 1 w to about 10 w power with a frequency from about 40 kHz to about 100 kHz and a speed of about 2 m/s to about 4 m/s. In a yet further aspect, laser etching is carried out at about 3.5 w power with a frequency of about 40 kHz and a speed of about 2 m/s (as used herein "w" means watts; "kHz" or "KHz" means kilohertz; "m/s" means meter/second).

In a further aspect, a rough surface may form in the LDS process. In a still further aspect, the rough surface may entangle the copper plate with the LDS-containing layer material which may provide adhesion between the copper plate and the layer.

A metalizing step can, in various aspects, be performed using conventional techniques. For example, in one aspect, an electroless copper plating bath is used during the metallization step in the LDS process. Thus, in various aspects, plating a metal layer onto a conductive path is metallization. In a still further aspect, metallization can comprise the steps: a) cleaning the etched surface; b) additive build-up of tracks; and c) plating.

The LDS additive can remain on the surface of a layer in the areas not irradiated by the laser. In one embodiment, the metal layer has a peel strength of 0.7 N/mm (as used herein "N/mm" means newton/millimeter) or higher (according to ASTM D1876-08) (unless specified to the contrary herein, all test standards herein are the most recent standard in effect at the effective filing date of this application). In still another embodiment, the metal layer has a peel strength of 0.8 N/mm or higher. The thickness of the metal layer is, in one embodiment, 0.8 microns or higher. In another embodiment, the thickness of the metal layer is 1.0 microns or higher. In other embodiments the thickness of the metal is from about 30 microns to about 35 microns.

Articles that may be manufactured from the polymeric structures of the present disclosure include parts related to computer, a cell phone, communications equipment, a medical device, an RFID device, or an automotive part, electronics, etc. For example, applications for this disclosure include three-dimensional printed circuit boards; mechatronic components for automatic steering wheels, and antennas for mobile phones.

LDS materials of the present disclosure may be formed using three approaches. In the first approach, the single-layer film or the multi-layer polymeric sheet can be prepared in a flat shape by any of the processes mentioned previously, followed by laser-direct structuring and metal plating.

In a second approach is a thermoforming approach where the polymeric film or the polymeric sheet is shaped into a 3-D structure, followed by laser-direct structuring and metal plating. This approach is especially useful for co-extruded films and sheets.

In a third approach, the in-mold decoration (IMD) method is used to make MIDs. The IMD process typically begins with specialty films, flat or pre-formed, which are inserted into a mold before a part is manufactured. During molding, the film becomes an integral portion of the final part. In the in-mold decorating process, a printed substrate is formed into a three-dimensional shape and placed into a mold. Molten resin is then injected into the mold cavity space behind the formed substrate, forming a single molded part. A typical process involves a polymeric film or a polymeric sheet comprising LDS additives. Screen printing is done on the surface of a base layer that typically does not contain LDS additives. The polymeric film or the polymeric sheet is then thermoformed and trimmed to render it into a shape conforming to the article to be injection molded. The formed and trimmed film or sheet is then fitted into a mold. A molten resin, such as polycarbonate, is injected into the mold cavity behind the polymeric film or polymeric sheet to produce a one-piece, bonded three-dimensional product suitable for laser-direct structuring followed by electroless plating.

### EXPERIMENTAL

The LDS containing polycarbonate was labeled as DX-11355. The polycarbonate used as the base layer was labeled as ML9737-1111. Both polycarbonates were dried at 120°C for 4 hours before film extrusion. Randcastle™ multi-layer film extruder was used to make the extruded sheets listed in Table 1.

**Table 1 Extruded Sheets**

| Sheet No. | **Total Thickness µm** | **Thickness of cap layer DX-11355 µm** | **Thickness of base polycarbonate ML9737-111 µm** |
|---|---|---|---|
| 1. | 254 | 50 | 204 |
| 2. | 254 | 75 | 179 |
| 3. | 254 | 100 | 154 |

All samples demonstrated good plating performance. Plating index (PI) values for the three sheets were greater than 0.7, indicating good plating performance. Plating index was determined by testing the plated copper thickness using the XRF method with ASTM B568 standard.

Under the B568 standard, in the first step, molded plaques were prepared at different values of the three laser-related variables: power, frequency, and speed. In the next step, the laser structured plaques and the reference stick (Pocan™ DP 7102) were immersed in a copper-plating bath, up until the time the reference stick accumulated a copper thickness of about 5 µm. The plaque and the reference stick were removed from the copper bath, rinsed, and dried. The thickness of the copper layer was measured twice on both sides of the reference stick by the XRF method and the four readings are averaged (the "Xref' readings). Also, for each variable, power, frequency and speed, the thickness of copper was measured at two points for each film and averaged for that variable.

The Plating Index (PI) value is defined as the ratio of the average copper thickness for one variable to the average copper thickness for the reference stick, Xref.

**Sheet No. 1: Plating Index**

| | | | |
|---|---|---|---|
| **Power/Frequency/Speed Watts/KHz/(m/s)** | 10w/100KHZ spd=2m/s | 10w/70KHZ spd=2m/s | 10w/40KHZ spd=2m/s |
| **PI** | 1.42 | 1.43 | 1.4 |
| **Power/Frequency/Speed W atts/KHz/(m/s)** | 7w/80KHZ spd=4m/s | 5w/80KHZ spd=4m/s | 3w/80KHZ spd=4m/s |
| **PI** | 1.23 | 1.06 | 0.89 |
| **Power/Frequency/Speed W atts/KHz/(m/s)** | 5w/100KHZ spd=4m/s | 3w/100KHZ spd=4m/s | 9w/80KHZ spd=4m/s |
| **PI** | 1.1 | 0.82 | 1.2 |
| **Power/Frequency/Speed Watts/KHz/(m/s)** | 11w/100KHZ spd=4m/s | 9w/100KHZ spd=4m/s | 7w/100KHZ spd=4m/s |
| **PI** | 1.15 | 1.38 | 1.26 |
| **Power/Frequency/Speed Watts/KHz/(m/s)** | 2w/100KHZ spd=2m/s | 2w/70KHZ spd=2m/s | 2w/40KHZ spd=2m/s |
| **PI** | 1.01 | 1.23 | 1.33 |
| **Power/Frequency/Speed Watts/KHz/(m/s)** | 3w/100KHZ spd=2m/s | 3w/70KHZ spd=2m/s | 3w/40KHZ spd=2m/s |
| **PI** | 1.21 | 1.39 | 1.4 |
| **Power/Frequency/Speed Watts/KHz/(m/s)** | 5w/100KHZ spd=2m/s | 5w/70KHZ spd=2m/s | 5w/40KHZ spd=2m/s |
| **PI** | 1.31 | 1.38 | 1.55 |
| **Power/Frequency/Speed Watts/KHz/(m/s)** | 8w/100KHZ spd=2m/s | 8w/70KHZ spd=2m/s | 8w/40KHZ spd=2m/s |
| **PI** | 1.28 | 1.3 | 1.66 |

**Sheet No. 2: Plating Index**

| | | | |
|---|---|---|---|
| **Power/Frequency/Speed Watts/KHz/(m/s)** | 10w/100KHZ spd=2m/s | 10w/70KHZ spd=2m/s | 10w/40KHZ spd=2m/s |
| **PI** | 1.47 | 1.43 | 1.37 |
| **Power/Frequency/Speed W atts/KHz/(m/s)** | 7w/80KHZ spd=4m/s | 5w/80KHZ spd=4m/s | 3w/80KHZ spd=4m/s |
| **PI** | 1.22 | 1.08 | 0.91 |
| **Power/Frequency/Speed W atts/KHz/(m/s)** | 5w/100KHZ spd=4m/s | 3w/100KHZ spd=4m/s | 9w/80KHZ spd=4m/s |
| **PI** | 1.07 | 0.77 | 1.18 |
| **Power/Frequency/Speed W atts/KHz/(m/s)** | 11w/100KHZ spd=4m/s | 9w/100KHZ spd=4m/s | 7w/100KHZ spd=4m/s |
| **PI** | 1.46 | 1.39 | 1.46 |
| **Power/Frequency/Speed W atts/KHz/(m/s)** | 2w/100KHZ spd=2m/s | 2w/70KHZ spd=2m/s | 2w/40KHZ spd=2m/s |
| **PI** | 1.05 | 1.16 | 1.17 |
| **Power/Frequency/Speed W atts/KHz/(m/s)** | 3w/100KHZ spd=2m/s | 3w/70KHZ spd=2m/s | 3w/40KHZ spd=2m/s |
| **PI** | 1.15 | 1.42 | 1.23 |
| **Power/Frequency/Speed Watts/KHz/(m/s)** | 5w/100KHZ spd=2m/s | 5w/70KHZ spd=2m/s | 5w/40KHZ spd=2m/s |
| **PI** | 1.22 | 1.24 | 1.49 |
| **Power/Frequency/Speed Watts/KHz/(m/s)** | 8w/100KHZ spd=2m/s | 8w/70KHZ spd=2m/s | 8w/40KHZ spd=2m/s |
| **PI** | 1.91 | 1.8 | 1.66 |

**Sheet No. 3: Plating Index**

| | | | |
|---|---|---|---|
| **Power/Frequency/Speed Watts/KHz/(m/s)** | 10w/100KHZ spd=2m/s | 10w/70KHZ spd=2m/s | 10w/40KHZ spd=2m/s |
| **PI** | 1.63 | 1.61 | 1.49 |
| **Power/Frequency/Speed Watts/KHz/(m/s)** | 7w/80KHZ spd=4m/s | 5w/80KHZ spd=4m/s | 3w/80KHZ spd=4m/s |
| **PI** | 1.28 | 0.99 | 0.88 |
| **Power/Frequency/Speed W atts/KHz/(m/s)** | 5w/100KHZ spd=4m/s | 3w/100KHZ spd=4m/s | 9w/80KHZ spd=4m/s |
| **PI** | 1.13 | 0.76 | 1.37 |
| **Power/Frequency/Speed W atts/KHz/(m/s)** | 11w/100KHZ spd=4m/s | 9w/100KHZ spd=4m/s | 7w/100KHZ spd=4m/s |
| **PI** | 1.13 | 1.09 | 1.1 |
| **Power/Frequency/Speed W atts/KHz/(m/s)** | 2w/100KHZ spd=2m/s | 2w/70KHZ spd=2m/s | 2w/40KHZ spd=2m/s |
| **PI** | 0.93 | 1.15 | 1.21 |
| **Power/Frequency/Speed W atts/KHz/(m/s)** | 3w/100KHZ spd=2m/s | 3w/70KHZ spd=2m/s | 3w/40KHZ spd=2m/s |
| **PI** | 1.06 | 1.18 | 1.03 |
| **Power/Frequency/Speed Watts/KHz/(m/s)** | 5w/100KHZ spd=2m/s | 5w/70KHZ spd=2m/s | 5w/40KHZ spd=2m/s |
| **PI** | 1.17 | 1.19 | 1.12 |
| **Power/Frequency/Speed Watts/KHz/(m/s)** | 8w/100KHZ spd=2m/s | 8w/70KHZ spd=2m/s | 8w/40KHZ spd=2m/s |
| **PI** | 1.08 | 1.07 | 1.29 |

## Claims

1. A polymeric sheet comprising:
a first cap layer comprising a first laser-direct structuring (LDS) additive, wherein the first LDS additive is selected from the group consisting of copper chromium oxide spinel, copper hydroxide phosphate, copper phosphate, copper chromium oxide spinel, a copper sulfate, a cuprous thiocyanate, an organic metal complex, a palladium/palladium-containing heavy metal complex, a metal oxide, a metal oxide-coated filler, antimony doped tin oxide coated on mica, a copper containing metal oxide, a zinc containing metal oxide, a tin containing metal oxide, a magnesium containing metal oxide, an aluminum containing metal oxide, a gold containing metal oxide, a silver containing metal oxide, and a combination thereof, and
a base layer;
wherein said first cap layer contacts said base layer,
wherein the first cap layer and the base layer comprise a polymeric resin, and
wherein the base layer is free of LDS additives.

2. The polymeric sheet of claim 1, wherein said sheet is a co-extruded thermoplastic material.

3. The polymeric sheet of any of claims 1 or 2, wherein each of said first cap layer and said base layer comprise a thermoplastic resin selected from the group consisting of polycarbonate, acrylonitrile-butadiene-styrene, polyimide, poly(arylene ether), polyamide, polyester, polyphthalamide, polyphenylene oxide, polyetherimide, polyketones, polyetherketones, polybenzimidazole, polystyrene, polymethyl methacrylate, polyvinylchloride, cellulose-acetate, polyacrylonitrile, polysulphone, polyphenylenesulfide, fluoropolymers, polycarbonate/acrylonitrile-butadiene-styrene resin blend, acrylonitrile-ethylene/propylene-styrene, methyl methacrylate-butadiene-styrene, acrylonitrile-butadiene-methyl methacrylate-styrene, acrylonitrile-n-butyl acrylate-styrene, rubber modified polystyrene, polyethylene, polypropylene, silicone, polyamide elastomer, polyester based elastomers, and combinations thereof.

4. The polymeric sheet of any of claims 1-3, wherein the first LDS additive comprises copper chromium oxide spinel, copper hydroxide phosphate, copper phosphate, or mixtures thereof.

5. The polymeric sheet of any of claims 1-4, wherein said first cap layer is from about 5% to about 30% of the total thickness of said polymeric sheet.

6. The polymeric sheet of any of claims 1-5, wherein said first cap layer has the thickness in the range of from about 10 µm to about 12,500 µm.

7. The polymeric sheet of any of claims 1-6, wherein the base layer has at least two sides, and further comprising a second cap layer in contact with said base layer on an opposite side of that of the first cap layer, wherein said second layer comprises a second LDS additive.

8. The polymeric sheet of any of claims 1-6, wherein the cap layer and the base layer are adhered to each other.

9. An article of manufacture comprising a molded article formed from the polymeric sheet of any of claims 1-8, wherein a conductive path is formed on the molded article and a metal layer is plated on the conductive path.

10. The article of claim 9, wherein the molded article is cylindrical, spherical, annular, tubular, ovoid, a regular 3-D shape, or an irregular 3-D shape.

11. A method of forming an article comprising:
molding an article from the polymeric sheet of any of claims 1-7;
forming a conductive path on said molded article; and
plating a metal layer onto said conductive path.

12. The method of claim 11, wherein molding the article comprises shaping the polymeric sheet of any of claims 1-7 into a three-dimensional structure.

13. The method of claim 11, wherein forming a conductive path comprises activating a surface of the molded article with a laser.

## Patentansprüche

1. Eine Polymerfolie, umfassend:
eine erste Deckschicht, die ein erstes Laser-Direktstrukturierungs-Additiv (LDS) umfasst, wobei das erste LDS-Additiv ausgewählt ist aus der Gruppe bestehend aus Kupferchromoxid-Spinell, Kupferhydroxidphosphat, Kupferphosphat, Kupferchromoxid-Spinell, einem Kupfersulfat, einem Kupferthiocyanat, einem organischen Metallkomplex, einem Palladium/Palladium-haltigen Schwermetallkomplex ein Metalloxid, ein metalloxidbeschichteter Füllstoff, ein auf Glimmer beschichtetes antimondotiertes Zinnoxid, ein kupferhaltiges Metalloxid, ein zinkhaltiges Metalloxid, ein zinnhaltiges Metalloxid, ein magnesiumhaltiges Metalloxid, ein aluminiumhaltiges Metalloxid, ein goldhaltiges Metalloxid, ein silberhaltiges Metalloxid und eine Kombination davon, und
eine Basisschicht;
wobei die erste Deckschicht die Basisschicht berührt,
wobei die erste Deckschicht und die Basisschicht ein polymeres Harz umfassen und wobei die Basisschicht frei von LDS-Additiven ist.

2. Die Polymerfolie nach Anspruch 1, wobei die Folie ein co-extrudiertes thermoplastisches Material ist.

3. Die Polymerfolie nach einem der Ansprüche 1 oder 2, wobei die erste Deckschicht und die Basisschicht jeweils ein thermoplastisches Harz umfassen, ausgewählt aus der Gruppe bestehend aus Polycarbonat, Acrylnitril-Butadien-Styrol, Polyimid, poly(arylenether), Polyamid, Polyester, Polyphthalamid, Polyphenylenoxid, Polyetherimid, Polyketone, Polyetherketone, Polybenzimidazol, Polystyrol, Polymethylmethacrylat, Polyvinylchlorid, Cellulose-Acetat, Polyacrylnitril, Polysulfon, Polyphenylensulfid, Fluorpolymere, Polycarbonat/Acrylnitril-Butadien-Styrol-Harzmischung, Acrylnitril-Ethylen/Propylen-Styrol, Methylmethacrylat-Butadien-Styrol, Acrylnitril-Butadien-Methylmethacrylat-Styrol, Acrylnitril-n-Butylacrylat-Styrol, kautschukmodifiziertes Polystyrol, Polyethylen, Polypropylen, Silikon, Polyamidelastomer, Elastomere auf Polyesterbasis und Kombinationen davon.

4. Die Polymerfolie nach einem der Ansprüche 1 bis 3, wobei das erste LDS-Additiv Kupferchromoxidspinell, Kupferhydroxidphosphat, Kupferphosphat oder Mischungen davon umfasst.

5. Die Polymerfolie nach einem der Ansprüche 1 bis 4, wobei die erste Deckschicht etwa 5 % bis etwa 30 % der Gesamtdicke der Polymerfolie ausmacht.

6. Die Polymerfolie nach einem der Ansprüche 1 bis 5, wobei die erste Deckschicht eine Dicke im Bereich von etwa 10 µm bis etwa 12.500 µm aufweist

7. Die Polymerfolie nach einem der Ansprüche 1 bis 6, wobei die Basisschicht mindestens zwei Seiten aufweist und ferner eine zweite Deckschicht in Kontakt mit der Basisschicht auf einer der ersten Deckschicht gegenüberliegenden Seite umfasst, wobei die zweite Schicht ein zweites LDS-Additiv umfasst.

8. Die Polymerfolie nach einem der Ansprüche 1 bis 6, wobei die Deckschicht und die Basisschicht miteinander verklebt sind.

9. Ein Erzeugnis, umfassend ein geformtes Erzeugnis, das aus der Polymerfolie nach einem der Ansprüche 1 bis 8 gebildet ist, wobei ein leitender Pfad auf dem geformten Erzeugnis gebildet ist und eine Metallschicht auf den leitenden Pfad plattiert ist.

10. Das Erzeugnis nach Anspruch 9, wobei das geformte Erzeugnis zylindrisch, kugelförmig, ringförmig, rohrförmig, eiförmig, eine regelmäßige 3-D-Form oder eine unregelmäßige 3-D-Form ist.

11. Ein Verfahren zum Formen eines Erzeugnisses, umfassend:
das Formen eines Erzeugnisses aus der Polymerfolie nach einem der Ansprüche 1 bis 7;
das Formen eines leitenden Pfades auf dem geformten Erzeugnis; und
das Aufbringen einer Metallschicht auf den leitenden Pfad.

12. Das Verfahren nach Anspruch 11, wobei das Formen des Erzeugnisses das Verformen der Polymerfolie nach einem der Ansprüche 1 bis 7 zu einer dreidimensionalen Struktur umfasst.

13. Das Verfahren nach Anspruch 11, wobei das Formen eines leitenden Pfades das Aktivieren einer Oberfläche des geformten Erzeugnisses mit einem Laser umfasst.

## Revendications

1. Une feuille polymère comprenant :
une première couche de recouvrement comprenant un premier additif de structuration dirigée par laser (LDS), dans laquelle le premier additif LDS est choisi dans le groupe constitué par le spinelle d'oxyde de chrome de cuivre, le phosphate d'hydroxyde de cuivre, le phosphate de cuivre, le spinelle d'oxyde de chrome de cuivre, un sulfate de cuivre, un thiocyanate cuivreux, un complexe métallique organique, un complexe de métal lourd contenant du palladium/du palladium, un oxyde métallique, une charge revêtue d'oxyde métallique, un oxyde d'étain dopé à l'antimoine revêtu de mica, un oxyde métallique contenant du cuivre, un oxyde métallique contenant du zinc, un oxyde métallique contenant de l'étain, un oxyde métallique contenant du magnésium, un oxyde métallique contenant de l'aluminium, un oxyde métallique contenant de l'or, un oxyde métallique contenant de l'argent, et une combinaison de ceux-ci, et
une couche de base ;
dans lequel ladite première couche de recouvrement est en contact avec ladite couche de base,
dans lequel la première couche de recouvrement et la couche de base comprennent une résine polymère, et dans lequel la couche de base est exempte d'additifs LDS.

2. Feuille polymère selon la revendication 1, dans laquelle ladite feuille est un matériau thermoplastique co-extrudé.

3. Feuille polymère de l'une quelconque des revendications 1 ou 2, dans laquelle chacune de ladite première couche de recouvrement et de ladite couche de base comprend une résine thermoplastique choisie dans le groupe constitué par le polycarbonate, l'acrylonitrile-butadiène-styrène, le polyimide, poly(arylène éther), polyamide, polyester, polyphtalamide, poly(oxyde de phénylène), polyétherimide, polycétones, polyéthercétones, polybenzimidazole, polystyrène, polyméthacrylate de méthyle, polychlorure de vinyle, acétate de cellulose, polyacrylonitrile, polysulfone, polyphénylènesulfure, fluoropolymères, mélange de résine polycarbonate/acrylonitrile-butadiène-styrène, acrylonitrile-éthylène/propylène-styrène, méthacrylate de méthyle-butadiène-styrène, acrylonitrile-butadiène-méthacrylate de méthyle-styrène, acrylonitrile-n-butyl acrylate-styrène, polystyrène modifié par du caoutchouc, polyéthylène, polypropylène, silicone, élastomère polyamide, élastomères à base de polyester, et leurs combinaisons.

4. Feuille polymère de l'une quelconque des revendications 1 à 3, dans laquelle le premier additif LDS comprend du spinelle d'oxyde de cuivre et de chrome, du phosphate d'hydroxyde de cuivre, du phosphate de cuivre, ou des mélanges de ceux-ci.

5. Feuille polymère de l'une quelconque des revendications 1 à 4, dans laquelle ladite première couche de recouvrement représente d'environ 5 % à environ 30 % de l'épaisseur totale de ladite feuille polymère.

6. La feuille polymère de l'une quelconque des revendications 1 à 5, dans laquelle ladite première couche de recouvrement a une épaisseur comprise entre environ 10 µm et environ 12 500 µm.

7. Feuille polymère de l'une quelconque des revendications 1 à 6, dans laquelle la couche de base a au moins deux côtés, et comprenant en outre une seconde couche de recouvrement en contact avec ladite couche de base sur un côté opposé à celui de la première couche de recouvrement, dans laquelle ladite seconde couche comprend un second additif LDS.

8. Feuille polymère de l'une quelconque des revendications 1 à 6, dans laquelle la couche de recouvrement et la couche de base sont collées l'une à l'autre.

9. Article de fabrication comprenant un article moulé formé à partir de la feuille polymère de l'une quelconque des revendications 1 à 8, dans lequel un trajet conducteur est formé sur l'article moulé et une couche métallique est plaquée sur le trajet conducteur.

10. Article de la revendication 9, dans lequel l'article moulé est cylindrique, sphérique, annulaire, tubulaire, ovoïde, de forme régulière en 3D ou de forme irrégulière en 3D.

11. Procédé de formation d'un article comprenant :
le moulage d'un article à partir de la feuille polymère de l'une quelconque des revendications 1 à 7 ;
la formation d'un trajet conducteur sur ledit article moulé ;
et le placage d'une couche métallique sur ledit trajet conducteur.

12. Procédé de la revendication 11, dans lequel le moulage de l'article comprend le façonnage de la feuille polymère de l'une quelconque des revendications 1 à 7 en une structure tridimensionnelle.

13. Procédé de la revendication 11, dans lequel la formation d'un chemin conducteur comprend l'activation d'une surface de l'article moulé avec un laser.
